# EUROPEAN PATENT APPLICATION

(11) **EP 4 709 071 A1**
(43) Date of publication of application: **11.03.2026**
(21) Application number: 25198223.7
(22) Date of filing: 26.08.2025
(51) Int. Cl.: H05K 7/20

(54) **POWER CONVERSION SYSTEM**

(30) Priority: 03.09.2024 CN 202411234356
(71) Applicant: Huawei Digital Power Technologies Co., Ltd., Shenzhen, Guangdong 518043 (CN)
(72) Inventor: WANG, Jie, Shenzhen, 518043 (CN); SUN, Faming, Shenzhen, 518043 (CN); XU, Juwu, Shenzhen, 518043 (CN)
(74) Representative: Isarpatent

(57) **Abstract**

This application provides a power conversion system, including a plurality of power converters and two partition plates. The plurality of power converters include a first layer of power converters and a second layer of power converters that are stacked and spaced apart in a first direction, and the first layer of power converters is closer to the ground than the second layer of power converters. The first layer of power converters includes a first column of power converters and a second column of power converters that are disposed opposite to each other and spaced apart in a second direction, and the second layer of power converters includes a third column of power converters and a fourth column of power converters that are disposed opposite to each other and spaced apart in the second direction. Each column of power converters includes at least two power converters that are spaced apart in a third direction. The power converter includes an air inlet and an air outlet, and the air inlet is closer to the ground than the air outlet. One of the two partition plates is located between the first column of power converters and the third column of power converters, the other partition plate is located between the second column of power converters and the fourth column of power converters, and the one partition plate and the other partition plate are symmetrically disposed.

## Description

### TECHNICAL FIELD

This application relates to the field of new energy power generation, and in particular, to a power conversion system.

### BACKGROUND

A power converter (for example, a power conversion system or a photovoltaic inverter) is one of core devices of a photovoltaic power generation system, and is configured to: convert a direct current from a photovoltaic module or an energy storage battery into an alternating current, and transmit the alternating current to a power grid or a load. In recent years, with rapid development of the photovoltaic power generation industry, there is an increasingly high requirement for a capacity and power density of the power converter, and a centralized and integrated layout of a plurality of power converters becomes a development trend of the industry. Based on this, when the plurality of power converters are in a centralized and integrated layout, how to appropriately design the layout and a heat dissipation structure of the power converters to improve a heat dissipation capability of a system and further improve power conversion efficiency of the power converters becomes an urgent problem to be resolved in the industry.

### SUMMARY

Based on the foregoing technical problem, this application provides a power conversion system, so that a high heat dissipation capability of the system can be ensured when a plurality of power converters are integrated, and power conversion efficiency of the power conversion system can be improved.

According to a first aspect, this application provides a power conversion system, including a plurality of power converters and two partition plates. The plurality of power converters are configured to: convert a direct current from a photovoltaic module or an energy storage battery into an alternating current, and transmit the alternating current to a power grid. The plurality of power converters include at least two layers of power converters that are stacked and spaced apart in a first direction, each layer of power converters in the at least two layers of power converters includes at least two columns of power converters that are disposed opposite to each other and spaced apart in a second direction, and each column of power converters in the at least two columns of power converters includes at least two power converters that are spaced apart in a third direction. The first direction, the second direction, and the third direction are perpendicular to each other. The power converter further includes an air inlet and an air outlet. Air outside the power converter enters the power converter from the air inlet and then is blown out from the air outlet, and the air inlet is closer to the ground than the air outlet in the first direction. The at least two layers of power converters include a first layer of power converters and a second layer of power converters that are adjacent, and the first layer of power converters is closer to the ground than the second layer of power converters in the first direction. The first layer of power converters includes a first column of power converters and a second column of power converters, the second layer of power converters includes a third column of power converters and a fourth column of power converters, and in the first direction, the first column of power converters and the third column of power converters are stacked and spaced apart, and the second column of power converters and the fourth column of power converters are stacked and spaced apart. One of the two partition plates is disposed between an air outlet of a power converter in the first column of power converters and an air inlet of a power converter in the third column of power converters, and the other of the two partition plates is disposed between an air outlet of a power converter in the second column of power converters and an air inlet of a power converter in the fourth column of power converters. Both the one partition plate and the other partition plate extend in the second direction and the third direction, and the one partition plate and the other partition plate are symmetrically disposed.

It should be noted that, when the power converter works normally, components such as a power module and an inverter inductor inside the power converter generate a large amount of heat. To better dissipate the heat, a heat sink needs to be equipped for the power module, the inverter inductor, and the like. The heat sink is usually provided with a plurality of fins, to dissipate the heat to the atmosphere. To improve heat dissipation efficiency, a fan is generally further equipped between the air inlet and the air outlet of the power converter, so that cold air in the atmosphere is blown to the heat sink and takes away heat of the heat sink. Finally, hot air is discharged into the atmosphere again through the air outlet. Because density of the hot air is smaller than that of the cold air, a moving direction of the hot air is opposite to a gravity direction in a natural state. Based on this, the air inlet is provided at a position closer to the ground than the air outlet, so that heat can be better dissipated for the power converter.

Further, because the one partition plate is located between the air outlet of the power converter in the first column of power converters and the air inlet of the power converter in the third column of power converters, hot air blown out from the power converter in the first column of power converters is not directly sucked into the air inlet of the power converter in the third column of power converters, so that cooling efficiency of the power converter in the third column of power converters is ensured. Similarly, because the other partition plate is located between the air outlet of the power converter in the second column of power converters and the air inlet of the power converter in the fourth column of power converters, hot air blown out from the power converter in the second column of power converters is not directly sucked into the air inlet of the power converter in the fourth column of power converters, so that cooling efficiency of the power converter in the fourth column of power converters is ensured. Further, because the one partition plate and the other partition plate are symmetrically disposed, the hot air blown out from the first column of power converters is not directly sucked into the air inlet of the power converter in the fourth column of power converters, and the hot air blown out from the second column of power converters is not directly sucked into the air inlet of the power converter in the third column of power converters, so that the cooling efficiency of the power converter in the fourth column of power converters is ensured.

In a possible implementation, a projection of the first column of power converters in the first direction is located within a contour range of a projection of the one partition plate, and a projection of the second column of power converters in the first direction is located within a contour range of a projection of the other partition plate.

Through this disposition, the hot air blown out from the air outlet of the power converter in the first layer of power converters can be prevented, to a greatest extent, from being sucked into the air inlet of the power converter in the second layer of power converters by bypassing edges of the partition plates, so that the heat dissipation efficiency of the power conversion system is improved.

In a possible implementation, both the one partition plate and the other partition plate are disposed obliquely relative to the first direction.

Through this disposition, air in the atmosphere is more likely to be sucked by the air inlet of the power converter in the second layer of power converters.

In a possible implementation, a distance between the one partition plate and the third column of power converters in the first direction gradually decreases as a distance between the one partition plate and the second column of power converters or the fourth column of power converters in the second direction decreases, and a distance between the other partition plate and the fourth column of power converters in the first direction gradually decreases as a distance between the other partition plate and the first column of power converters or the third column of power converters in the second direction decreases. That is, the two partition plates symmetrically form a shape similar to a splayed shape.

Based on this, air outside the power conversion system enters the power converter from air inlets of the first column of power converters and the second column of power converters, and then is discharged from the power converter through the air outlet, and due to the inclined partition plate, the discharged air may be more likely to be guided by the partition plate. Then, instead of being directly sucked by air inlets of the second layer of power converters, air discharged from the first column of power converters and the second column of power converters converges in a passage between the third column of power converters and the fourth column of power converters. In addition, due to the inclined partition plate, the second layer of power converters is more likely to suck cold air from the outside of the power conversion system. This avoids sucking hot air discharged from the first layer of power converters, hot air recirculation of the power conversion system is further avoided, and the heat dissipation efficiency of the power conversion system is improved.

In a possible implementation, a distance between the one partition plate and the third column of power converters in the first direction gradually increases as a distance between the one partition plate and the second column of power converters or the fourth column of power converters in the second direction decreases, and a distance between the other partition plate and the fourth column of power converters in the first direction gradually increases as a distance between the other partition plate and the first column of power converters or the third column of power converters in the second direction decreases. That is, the two partition plates symmetrically form a shape similar to an inverted splayed shape.

Based on this, air outside the power conversion system enters the power converter from air inlets of the first layer of power converters, and then is discharged from the power converter through the air outlet, and due to the inclined partition plate, the discharged air may be more likely to be guided to the outside of the power conversion system by the partition plate, instead of being directly sucked by air inlets of the second layer of power converters. In addition, due to the inclined partition plate, cold air outside the power conversion system enters the inside of the power conversion system through a passage between the first column of power converters and the second column of power converters. Then, the cold air in the passage is more likely to be sucked by air inlets of the third column of power converters and the fourth column of power converters separately, so that hot air recirculation of the power conversion system is further avoided, and the heat dissipation efficiency of the power conversion system is improved.

In a possible implementation, the air outlet includes a left air outlet and a right air outlet that are disposed opposite to each other in the second direction. The power conversion system further includes two first baffle plates, the first baffle plate extends toward the ground in the first direction, one of the two first baffle plates is fastened to an end of the one partition plate in the second direction, and the other of the two first baffle plates is fastened to an end of the other partition plate in the second direction. The first baffle plate is disposed opposite to the left air outlet or the right air outlet in the second direction, and the first baffle plate is configured to shield the left air outlet or the right air outlet.

Through this disposition, hot air blown out from a left air outlet or a right air outlet of a power converter in the first layer of power converters can be prevented, to a greatest extent, from being sucked into the air inlet of the power converter in the second layer of power converters by bypassing edges of the partition plates, so that the heat dissipation efficiency of the power conversion system is improved.

In a possible implementation, in the first direction, an end portion that is of the one first baffle plate and that is close to the ground is closer to the ground than a left air outlet of any power converter in the first column of power converters, the one first baffle plate is configured to shield left air outlets of the first column of power converters, an end portion that is of the other first baffle plate and that is close to the ground is closer to the ground than a right air outlet of any power converter in the second column of power converters, and the other first baffle plate is configured to shield right air outlets of the second column of power converters.

In other words, a projection of the left air outlet of any power converter in the first column of power converters in the second direction is located within a contour range of the one first baffle plate, and a projection of the right air outlet of any power converter in the second column of power converters in the second direction is located within a contour range of the other first baffle plate. Through this disposition, the hot air blown out from the first column of power converters can be better prevented from being sucked by an air inlet of a power converter in the third column of power converters by bypassing the one first baffle plate, and the hot air blown out from the second column of power converters can be better prevented from being sucked by an air inlet of a power converter in the fourth column of power converters by bypassing the other first baffle plate, so that the heat dissipation efficiency of the power conversion system is improved.

In a possible implementation, in the first direction, an end portion that is of the one first baffle plate and that is close to the ground is closer to the ground than a right air outlet of any power converter in the first column of power converters, the one first baffle plate is configured to shield right air outlets of the first column of power converters, an end portion that is of the other first baffle plate and that is close to the ground is closer to the ground than a left air outlet of any power converter in the second column of power converters, and the other first baffle plate is configured to shield left air outlets of the second column of power converters.

In other words, a projection of the right air outlet of any power converter in the first column of power converters in the second direction is located within a contour range of the one first baffle plate, and a projection of the left air outlet of any power converter in the second column of power converters in the second direction is located within a contour range of the other first baffle plate. Through this disposition, the hot air blown out from the first column of power converters can be better prevented from being sucked by an air inlet of a power converter in the third column of power converters by bypassing the one first baffle plate, and the hot air blown out from the second column of power converters can be better prevented from being sucked by an air inlet of a power converter in the fourth column of power converters by bypassing the other first baffle plate, so that the heat dissipation efficiency of the power conversion system is improved.

In a possible implementation, the power conversion system further includes two second baffle plates, both the two second baffle plates extend away from the ground in the first direction, one of the two second baffle plates is fastened to the other end of the one partition plate in the second direction, the other of the two second baffle plates is fastened to the other end of the other partition plate in the second direction, the one second baffle plate is configured to shield an air inlet of any power converter in the third column of power converters, and the other second baffle plate is configured to shield an air inlet of any power converter in the fourth column of power converters.

When there is strong air convection in the second direction outside the power conversion system, the second baffle plates are disposed, so that the external air convection can be prevented, to a greatest extent, from blowing, into the air inlet of the power converter in the third column of power converters or the air inlet of the power converter in the fourth column of power converters, the hot air discharged from the first column of power converters and the second column of power converters, and the heat dissipation efficiency of the power conversion system is improved.

In a possible implementation, in the first direction, an end portion that is of the one second baffle plate and that is away from the ground is farther away from the ground than the air inlet of any power converter in the third column of power converters, and an end portion that is of the other second baffle plate and that is away from the ground is farther away from the ground than the air inlet of any power converter in the fourth column of power converters.

In other words, in the second direction, the one second baffle plate shields the air inlet of any power converter in the third column of power converters, and the other second baffle plate shields the air inlets of the fourth column of power converters. Through this disposition, hot air can be better prevented from being sucked by the air inlets of the third column of power converters by bypassing the one second baffle plate, and hot air can be better prevented from being sucked by the air inlets of the fourth column of power converters by bypassing the other second baffle plate.

In a possible implementation, the air outlet includes at least one of a front air outlet and a rear air outlet, both an air direction in which air is blown out from the front air outlet and an air direction in which air is blown out from the rear air outlet extend in the third direction, and when both the front air outlet and the rear air outlet exist, the front air outlet and the rear air outlet are disposed opposite to each other in the third direction. The power conversion system further includes one or more third baffle plates, and the third baffle plate is connected between two adjacent power converters in any column of power converters among the first column of power converters, the second column of power converters, the third column of power converters, or the fourth column of power converters. In the first direction, a third baffle plate connected between two adjacent power converters in the first column of power converters is closer to the ground than front air outlets or rear air outlets of the two power converters connected to the third baffle plate, a third baffle plate connected between two adjacent power converters in the second column of power converters is closer to the ground than front air outlets or rear air outlets of the two power converters connected to the third baffle plate, a third baffle plate connected between two adjacent power converters in the third column of power converters is closer to the ground than front air outlets or rear air outlets of the two power converters connected to the third baffle plate, and a third baffle plate connected between two adjacent power converters in the fourth column of power converters is closer to the ground than front air outlets or rear air outlets of the two power converters connected to the third baffle plate.

Through this disposition, when there is strong external convection in the first direction, hot air discharged from an air outlet of a power converter in any column of power converters can be prevented from being sucked by an air inlet of the power converter or an air inlet of a power converter adjacent to the power converter due to the strong external convection, so that the heat dissipation efficiency of the power conversion system is improved.

In a possible implementation, in the second direction, an edge of the third baffle plate located between the two adjacent power converters exceeds edges of the two adjacent power converters.

Through this disposition, hot air can be prevented, to a greatest extent, from being sucked by air inlets of the two adjacent power converters by bypassing the edge of the third baffle plate between the two adjacent power converters, so that the heat dissipation efficiency of the power conversion system is improved.

In a possible implementation, in the second direction, an edge of the third baffle plate located between the two adjacent power converters is flush with edges of the two adjacent power converters.

Through this disposition, hot air can be prevented, to a greatest extent, from being sucked by air inlets of the two adjacent power converters by bypassing the edge of the third baffle plate between the two adjacent power converters, so that the heat dissipation efficiency of the power conversion system is improved.

In a possible implementation, the power conversion system further includes one or more fourth baffle plates, the fourth baffle plate extends in the first direction and the third direction, and the fourth baffle plate is disposed in a spacing region between the first column of power converters and the second column of power converters. In the first direction, an end portion that is of the fourth baffle plate and that is away from the ground is farther away from the ground than air inlets of at least one column of power converters in the first layer of power converters, an end portion that is of the fourth baffle plate and that is close to the ground is closer to the ground than the air inlets of the at least one column of power converters in the first layer of power converters, and the first layer of power converters is a layer of power converters closest to the ground in the power conversion system.

When there is strong external convection in the second direction, the fourth baffle plate is disposed, so that the strong convection can be prevented from quickly flowing between the bottoms of the first column of power converters and the second column of power converters, air intake volumes of the first column of power converters and the second column of power converters are further increased, and the heat dissipation efficiency of the power conversion system is improved.

In a possible implementation, when the power conversion system includes two fourth baffle plates, one of the two fourth baffle plates is disposed opposite to the other fourth baffle plate in the second direction. In the second direction, a distance between the one fourth baffle plate and the first column of power converters is less than a distance between the other fourth baffle plate and the first column of power converters, and a distance between the other fourth baffle plate and the second column of power converters is less than a distance between the one fourth baffle plate and the second column of power converters.

Through this disposition, air between the first column of power converters and the ground can be better blocked, and similarly, air between the second column of power converters and the ground can also be blocked, to increase the air intake volumes of the first column of power converters and the second column of power converters.

In a possible implementation, the power conversion system further includes one or more fourth baffle plates, the fourth baffle plate extends in the first direction and the second direction, and in the third direction, the fourth baffle plate is disposed on an outer side of at least one column of power converters in the first layer of power converters. In the first direction, an end portion that is of the fourth baffle plate and that is away from the ground is farther away from the ground than air inlets of the at least one column of power converters in the first layer of power converters, an end portion that is of the fourth baffle plate and that is close to the ground is closer to the ground than the air inlets of the at least one column of power converters in the first layer of power converters, and the first layer of power converters is a layer of power converters closest to the ground in the power conversion system.

When there is strong external convection in the third direction, the fourth baffle plate is disposed, so that the strong convection can be prevented from quickly flowing between the bottom of the first column of power converters and the bottom of the second column of power converters, air intake volumes of the first column of power converters and the second column of power converters are further increased, and the heat dissipation efficiency of the power conversion system is improved.

In a possible implementation, the power conversion system further includes one or more fifth baffle plates, and the fifth baffle plate is connected between two adjacent power converters in any column of power converters in the first column of power converters or the second column of power converters. In the first direction, a fifth baffle plate connected between two adjacent power converters in the first column of power converters is farther away from the ground than air inlets of the two power converters connected to the fifth baffle plate, and a fifth baffle plate connected between two adjacent power converters in the second column of power converters is farther away from the ground than air inlets of the two power converters connected to the fifth baffle plate.

When there is strong external convection in the first direction, the fifth baffle plate is disposed, so that hot air discharged from the air outlet of the power converter in the first column of power converters can be prevented, to a greatest extent, from being sucked by an air inlet of the power converter. Similarly, hot air discharged from the air outlet of the power converter in the second column of power converters can also be prevented, to a greatest extent, from being sucked by the air inlet of the power converter, so that the heat dissipation efficiency of the power conversion system is improved.

In a possible implementation, in the second direction, an edge of the fifth baffle plate located between the two adjacent power converters exceeds edges of the two adjacent power converters.

Through this disposition, hot air can be prevented, to a greatest extent, from being sucked by air inlets of the two adjacent power converters by bypassing the edge of the fifth baffle plate between the two adjacent power converters, so that the heat dissipation efficiency of the power conversion system is improved.

In a possible implementation, in the second direction, an edge of the fifth baffle plate located between the two adjacent power converters is flush with edges of the two adjacent power converters.

Through this disposition, hot air can be prevented, to a greatest extent, from being sucked by air inlets of the two adjacent power converters by bypassing the edge of the fifth baffle plate between the two adjacent power converters, so that the heat dissipation efficiency of the power conversion system is improved.

In a possible implementation, the power conversion system further includes one or more sixth baffle plates, the sixth baffle plate extends in the first direction and the second direction and abuts against the partition plate, the sixth baffle plate is located on an outer side of the plurality of power converters in the third direction, and projections of the plurality of power converters in the third direction are located within a contour range of the sixth baffle plate.

The sixth baffle plate is disposed, so that hot air discharged from a power converter that is arranged on an outermost side of the first column of power converters in the third direction can be prevented from being sucked, by bypassing an edge of the partition plate between the first column of power converters and the third column of power converters, by an air inlet of a power converter that is in the third column of power converters and that is disposed opposite to the power converter in the first direction. Similarly, hot air discharged from a power converter that is arranged on an outermost side of the second column of power converters in the third direction can also be prevented from being sucked, by bypassing an edge of the partition plate between the second column of power converters and the fourth column of power converters, by an air inlet of a power converter that is in the fourth column of power converters and that is disposed opposite to the power converter in the first direction. Therefore, the heat dissipation efficiency of the power conversion system is improved.

In a possible implementation, the power conversion system further includes one or more seventh baffle plates, the seventh baffle plate is of a frame shape and extends in the first direction, and the seventh baffle plate is sleeved on a periphery of any column of power converters in a layer of power converters farthest away from the ground in the at least two layers of power converters. In the first direction, an end portion that is of the seventh baffle plate and that is close to the ground is closer to the ground than an air outlet of any power converter in the column of power converters on which the seventh baffle plate is sleeved, and an end portion that is of the seventh baffle plate and that is away from the ground is farther away from the ground than the air outlet of any power converter in the column of power converters on which the seventh baffle plate is sleeved.

When there is strong external convection in the second direction or the third direction, the seventh baffle plate is disposed, so that the strong external convection can be blocked to a greatest extent, to smoothly discharge hot air by a topmost layer of power converters, and the heat dissipation efficiency of the power conversion system is improved.

In conclusion, in the power conversion system provided in this application, a partition plate and a plurality of baffle plates are disposed, to avoid hot air recirculation between an upper layer of power converters and a lower layer of power converters. In other words, it is ensured that air sucked by air inlets of each layer of power converters is cold air with minimizing mixing of hot air discharged from the power converter, so that the heat dissipation efficiency of the power conversion system is improved.

### BRIEF DESCRIPTION OF DRAWINGS

FIG. 1 is a three-dimensional diagram of a power conversion system according to Embodiment 1 in embodiments of this application;
FIG. 2 is a front view of a power conversion system according to Embodiment 1 of this application;
FIG. 3A is a three-dimensional diagram 1 of a power converter in a power conversion system according to any embodiment of this application;
FIG. 3B is a three-dimensional diagram 2 of a power converter in a power conversion system according to any embodiment of this application;
FIG. 4 is a three-dimensional diagram of a power conversion system according to Embodiment 2 of this application;
FIG. 5 is a front view of a power conversion system according to Embodiment 2 of this application;
FIG. 6 is a three-dimensional diagram of a power conversion system according to Embodiment 3 of this application;
FIG. 7 is a front view of a power conversion system according to Embodiment 3 of this application;
FIG. 8 is a three-dimensional diagram of a power conversion system according to Embodiment 4 of this application;
FIG. 9 is a front view of a power conversion system according to Embodiment 4 of this application;
FIG. 10 is a three-dimensional diagram of a power conversion system according to Embodiment 5 of this application;
FIG. 11 is a front view of a power conversion system according to Embodiment 5 of this application;
FIG. 12 is a three-dimensional diagram of a power conversion system according to Embodiment 6 of this application;
FIG. 13 is a front view of a power conversion system according to Embodiment 6 of this application;
FIG. 14 is a three-dimensional diagram of a power conversion system according to Embodiment 7 of this application;
FIG. 15 is a front view of a power conversion system according to Embodiment 7 of this application;
FIG. 16 is a three-dimensional diagram of a power conversion system according to Embodiment 8 of this application;
FIG. 17 is a three-dimensional diagram of a power conversion system according to Embodiment 9 of this application;
FIG. 18 is a front view of a power conversion system according to Embodiment 9 of this application;
FIG. 19 is a three-dimensional diagram of a power conversion system according to Embodiment 10 of this application; and
FIG. 20 is a front view of a power conversion system according to Embodiment 10 of this application.

### DESCRIPTION OF EMBODIMENTS

A power converter, for example, a photovoltaic inverter or a power conversion system (PCS), is a core device for achieving a power conversion function in a photovoltaic power station or an energy storage power station. The photovoltaic inverter is configured to: convert a direct current from a photovoltaic module into an alternating current, and transmit the alternating current to a power grid. The PCS is configured to: convert a direct current from an energy storage battery into an alternating current, and transmit the alternating current to the power grid. In addition, the PCS can further convert an alternating current from the power grid into a direct current, and charge the energy storage battery.

In recent years, to shorten a construction period of a new energy power station and simplify installation difficulty of a related device, centralized and integrated arrangement of a plurality of power converters has gradually become a development trend of the industry. However, with development of theoretical power density and a capacity of the power converter, a large amount of heat is generated in a working process of the power converter. When the plurality of power converters are in a centralized and integrated layout, how to properly arrange the power converters to avoid hot air recirculation between the power converters becomes a key factor that restricts improvement of power conversion efficiency of the power converter.

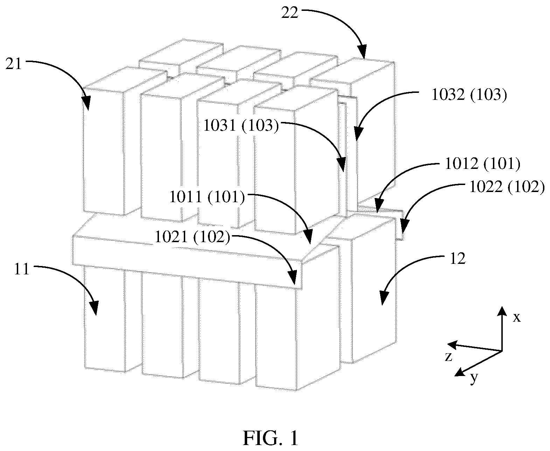

Based on this, this application provides several power conversion systems with high heat dissipation efficiency, so that a heat dissipation capability of the power conversion system can be ensured when the plurality of power converters are in a centralized layout. The following specifically describes, with reference to FIG. 1 to FIG. 20, the power conversion system provided in embodiments of this application.

### Embodiment 1:

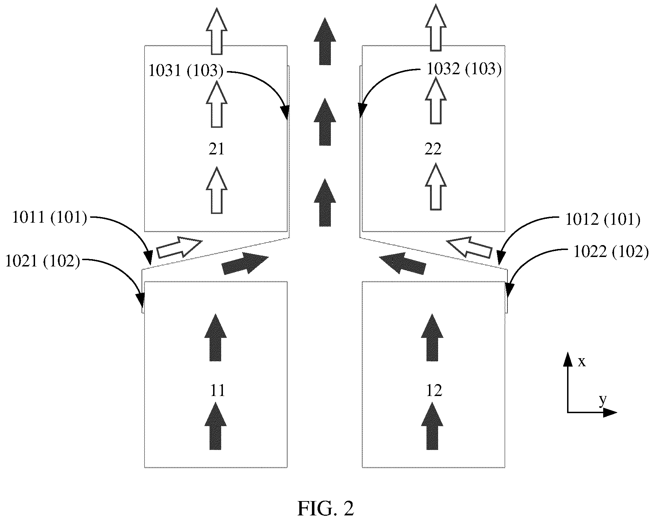

Refer to FIG. 1 and FIG. 2. FIG. 1 is a three-dimensional diagram of a power conversion system according to Embodiment 1 of this application, and FIG. 2 is a front view of the power conversion system according to Embodiment 1 of this application. The power conversion system includes a first layer of power converters and a second layer of power converters that are stacked and spaced apart in a first direction x. In the first direction x, the first layer of power converters is closer to the ground than the second layer of power converters. The first layer of power converters includes a first column of power converters 11 and a second column of power converters 12 that are disposed opposite to each other and spaced apart in a second direction y, and the second layer of power converters includes a third column of power converters 21 and a fourth column of power converters 22 that are disposed opposite to each other and spaced apart in the second direction y. In the first direction x, the first column of power converters 11 and the third column of power converters 21 are stacked and spaced apart, and the second column of power converters 12 and the fourth column of power converters 22 are stacked and spaced apart. Each column of power converters in the power conversion system includes at least two power converters that are spaced apart in a third direction z. The first direction x, the second direction y, and the third direction z are perpendicular to each other. Generally, when the ground is horizontal, the first direction x is a vertical direction, and the second direction y and the third direction z are horizontal directions.

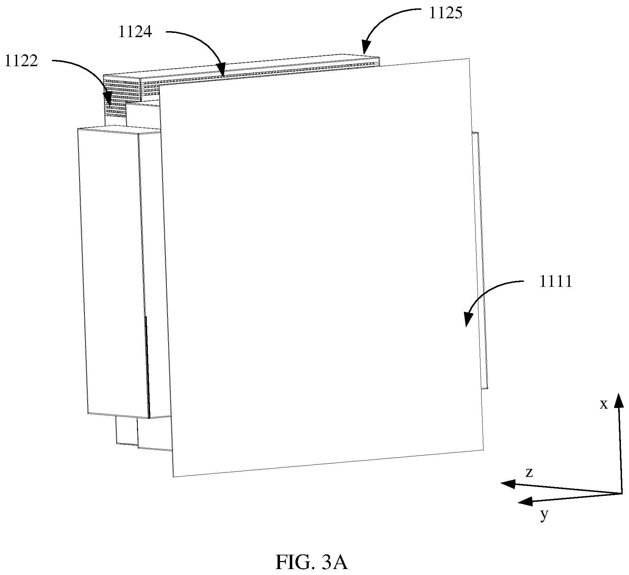

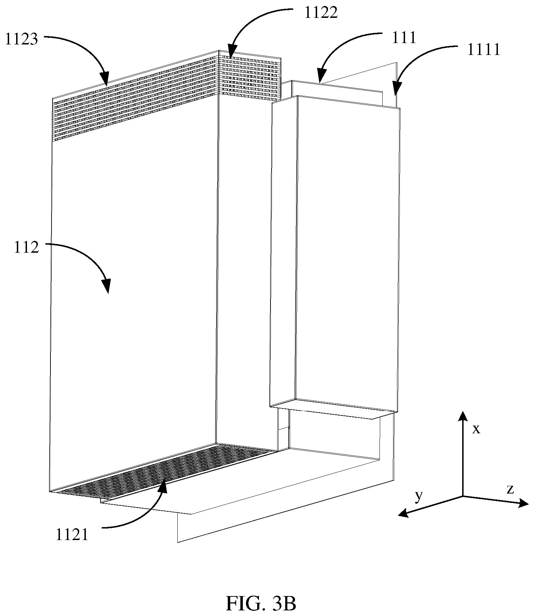

To simplify the accompanying drawings, in the accompanying drawings of the power conversion systems provided in all embodiments of this application, structures of power converters are all presented in a form of simple block. In the following, for ease of understanding stacking and arrangement manners of the power converters in the power conversion system, refer to FIG. 3A and FIG. 3B. FIG. 3A is a three-dimensional diagram 1 of a power converter in a power conversion system according to any embodiment of this application, and FIG. 3B is a three-dimensional diagram 2 of a power converter in a power conversion system according to any embodiment of this application. It should be noted that a display angle of view of the power converter in FIG. 3A is approximately the same as a display angle of view of the power converter in FIG. 1. Specifically, the power converter includes a power cavity 111 and a heat dissipation cavity 112 that are adjacent to each other, and the power cavity 111 and the heat dissipation cavity 112 are sequentially arranged in the third direction z. The power cavity 111 is configured to accommodate a circuit board and a component (such as a power module, a relay, or a capacitor) fastened to the circuit board. In addition, the power cavity 111 is further configured to accommodate a portion of an inductor, the other portion of the inductor is fastened to a heat sink, and at least a portion of the heat sink is disposed in the heat dissipation cavity 112. The heat dissipation cavity 112 includes an air inlet 1121 and an air outlet. Air outside the power converter enters the power converter from the air inlet 1121 to cool the heat sink of the power converter, and then is discharged from the air outlet. The air inlet 1121 is located at the bottom of the power converter, and the air outlet is located at the top of the power converter. In other words, in the first direction, an air inlet 1121 of a power converter in each layer of power converters is closer to the ground than an air outlet.

As described above, the power converter generates a large amount of heat in a working process. To dissipate the heat generated by the power converter in a timely manner, the inductor or the power module (for example, an insulated gate bipolar transistor, Insulated Gate Bipolar Transistor-IGBT) that generates a large amount of heat is fastened to the heat sink, a plurality of heat dissipation fins are usually disposed on the heat sink, to increase a contact area between the heat sink and air and improve heat dissipation efficiency. In addition, an air duct is further disposed between the air inlet 1121 and the air outlet of the power converter, and a fan (not shown) is usually further disposed in the air duct. Based on this, a wind pressure may be generated when the fan works, and the air outside the power converter is sucked into the power converter through the air inlet 1121 to cool the heat sink. After passing through the heat sink, the air may take away heat of the heat sink, and is finally discharged from the air outlet. It should be noted that, when the power converter works normally, because the air in the air duct carries a part of heat of the heat sink, a temperature of the air discharged from the air outlet is higher than a temperature of the air sucked through the air inlet 1121. In this case, hot air with lower air density naturally rises. Based on this, the air outlet is provided at the top of the power converter. After being sucked into the power converter, external cold air is more likely to be discharged from the air outlet after passing through the heat dissipation fins of the heat sink of the inductor or the power module.

Further, as shown in FIG. 3A and FIG. 3B, the air outlet includes a front air outlet 1124 and a rear air outlet 1123 that are disposed opposite to each other in the third direction z, and the air outlet further includes a left air outlet 1122 and a right air outlet 1125 that are disposed opposite to each other in the second direction y. It may be understood that, because the left air outlet 1122 and the right air outlet 1125 are disposed opposite to each other in the second direction, an air direction in which air is blown out from the left air outlet 1122 and an air direction in which air is blown out from the right air outlet 1125 also extend in the second direction y. It should be noted that, during actual application, the front air outlet 1124, the rear air outlet 1123, the left air outlet 1122, and the right air outlet 1125 may be provided as required. This is not limited in this application. For example, only one, two, three, or all of the front air outlet 1124, the rear air outlet 1123, the left air outlet 1122, and the right air outlet 1125 may be retained. It should be noted that the air outlet mentioned in all embodiments of this application is a general term, and the air outlet may be further subdivided.

Further, the power converter further includes a panel 1111. The panel 1111 is a front surface of the power converter. Generally, the panel 1111 is provided with an identifier indicating a brand source of the power converter. During actual application, an indicator indicating a working status of the power converter is further disposed on the panel 1111. When the power converter includes the front air outlet 1124, the panel 1111 is disposed opposite to the front air outlet 1124 in the third direction z, and the panel 1111 is configured to shield the front air outlet 1124. In other words, a projection of the front air outlet 1124 in the third direction z is located within a contour range of the panel 1111. Through this disposition, when a maintenance person is in front of the panel 1111, hot air blown out from the front air outlet 1124 is not directly blown to the maintenance person, so that safety of the maintenance person is ensured.

Further, the power conversion system further includes two partition plates 101, one partition plate 1011 of the two partition plates 101 is located between air outlets of the first column of power converters 11 and air inlets 1121 of the third column of power converters 21, and the other partition plate 1012 of the two partition plates 101 is located between air outlets of the second column of power converters 12 and air inlets 1121 of the fourth column of power converters 22.

Through this disposition, hot air blown out from the power converter in the first column of power converters 11 is not directly sucked into an air inlet 1121 of the power converter in the third column of power converters 21, so that cooling efficiency of the power converter in the third column of power converters 21 is ensured. Similarly, hot air blown out from the power converter in the second column of power converters 12 is not directly sucked into an air inlet 1121 of the power converter in the fourth column of power converters 22, so that cooling efficiency of the power converter in the fourth column of power converters 22 is ensured.

Further, both the two partition plates 101 extend in the second direction y and the third direction z, and the one partition plate 1011 and the other partition plate 1012 are symmetrically disposed.

Through this disposition, the hot air blown out from the first column of power converters 11 is not directly sucked into the air inlet 1121 of the power converter in the fourth column of power converters 22, and the hot air blown out from the second column of power converters 12 is not directly sucked into the air inlet 1121 of the power converter in the third column of power converters 21, so that the cooling efficiency of the power converter in the fourth column of power converters 22 is ensured.

Further, both the one partition plate 1011 and the other partition plate 1012 are disposed obliquely relative to the first direction x. For details, refer to FIG. 2. A distance between the one partition plate 1011 and the third column of power converters 21 in the first direction x gradually decreases as a distance between the one partition plate 1011 and the second column of power converters 12 or the fourth column of power converters 22 in the second direction y decreases, and a distance between the other partition plate 1012 and the fourth column of power converters 22 in the first direction x gradually decreases as a distance between the other partition plate 1012 and the first column of power converters or the third column of power converters 21 in the second direction y decreases. That is, the two partition plates 101 symmetrically form a shape similar to a splayed shape.

Through this disposition, hot air discharged from the air outlets of the first column of power converters 11 and the second column of power converters 12 converges in a passage between the third column of power converter and the fourth column of power converter, and is finally discharged from the power conversion system. Specifically, for a flow path of air that flows in the first layer of power converters and is discharged into the passage between the third column of power converter and the fourth column of power converter, refer to black arrows in FIG. 2. In addition, the two partition plates 101 are disposed obliquely, so that the hot air of the first column of power converters 11 and the second column of power converters 12 can be better guided and discharged. Moreover, the two partition plates 101 are disposed obliquely, so that air in the atmosphere is more likely to be sucked by the air inlet 1121 of the power converter in the second layer of power converters. Specifically, for a flow path of air in the second layer of power converters, refer to white arrows in FIG. 2.

Further, a projection of the first column of power converters 11 in the first direction x is located within a contour range of a projection of the one partition plate 1011, and a projection of the second column of power converters 12 in the first direction x is located within a contour range of a projection of the other partition plate 1012.

Through this disposition, the hot air blown out from the air outlet of the power converter in the first layer of power converters can be prevented, to a greatest extent, from being sucked into the air inlet 1121 of the power converter in the second layer of power converters by bypassing edges of the partition plates 101, so that heat dissipation efficiency of the power conversion system is improved.

It should be noted that, in an actual application process, the two partition plates 101 may alternatively extend only in the second direction y and the third direction z. In other words, the two partition plates are perpendicular to the first direction x. This is not limited in this application. In addition, in this application, a primary objective of symmetrically disposing the two partition plates 101 is to keep air discharging manners of the first column of power converters 11 and the second column of power converters 12 consistent. For example, air is discharged toward the inside of the power conversion system. In other words, air is discharged toward the passage between the first column of power converters 11 and the second column of power converters 12. Alternatively, air is discharged toward the outside of the power conversion system. Therefore, "symmetrically disposing" is not strictly mirror symmetry during actual application. Even if positions of the two partition plates 101 are slightly misplaced, or even if the one partition plate 1011 is horizontally disposed while the other partition plate 1012 is disposed obliquely relative to the first direction x, effect in which the air discharging manners are basically the same can also be achieved.

Still refer to FIG. 1 and FIG. 2. The power conversion system further includes two first baffle plates 102, and both the two first baffle plates 102 extend toward the ground in the first direction x. In the second direction y, one first baffle plate 1021 of the two first baffle plates 102 is fastened to an end of the one partition plate 1011, and the other first baffle plate 1022 of the two first baffle plates 102 is fastened to an end of the other partition plate 1012. Further, in the second direction y, the first baffle plate 102 is disposed opposite to the left air outlet 1122 or the right air outlet 1125. Specifically, in FIG. 2, the one first baffle plate 1021 is disposed opposite to a left air outlet 1122 of the first column of power converters 11, and is configured to shield the left air outlet 1122 of the first column of power converters 11, and the other first baffle plate 1022 is disposed opposite to a right air outlet 1125 of the second column of power converters 12, and is configured to shield the right air outlet 1125 of the second column of power converters 12.

Through this disposition, hot air blown out from the left air outlet 1122 or the right air outlet 1125 of the first layer of power converters can be prevented, to a greatest extent, from being sucked into the air inlet 1121 of the power converter in the second layer of power converters by bypassing edges of the partition plates 101, so that the heat dissipation efficiency of the power conversion system is improved.

Further, in the first direction x, an end portion that is of the one first baffle plate 1021 and that is close to the ground is closer to the ground than a left air outlet 1122 of any power converter in the first column of power converters 11, and an end portion that is of the other first baffle plate 1022 and that is close to the ground is closer to the ground than a right air outlet 1125 of any power converter in the second column of power converters 12.

In other words, a projection of the left air outlet 1122 of any power converter in the first column of power converters 11 in the second direction y is located within a contour range of the one first baffle plate 1021, and a projection of the right air outlet 1125 of any power converter in the second column of power converters 12 in the second direction y is located within a contour range of the other first baffle plate 1022. Through this disposition, the hot air blown out from the first column of power converters 11 can be better prevented from being sucked by the air inlet 1121 of the power converter in the third column of power converters 21 by bypassing the one first baffle plate 1021, and the hot air blown out from the second column of power converters 12 can be better prevented from being sucked by the air inlet 1121 of the power converter in the fourth column of power converters 22 by bypassing the other first baffle plate 1022, so that the heat dissipation efficiency of the power conversion system is improved.

It should be noted that, during actual application, a quantity of first baffle plates 102 may change with a mounting site and a mounting environment. For example, one of the one first baffle plate 1021 or the other first baffle plate 1022 may alternatively be retained. This is not limited in this application.

Still refer to FIG. 1 and FIG. 2. The power conversion system further includes two second baffle plates 103, and the two second baffle plates 103 are located in a passage between the third column of power converters 21 and the fourth column of power converters 22. Both the two second baffle plates 103 extend away from the ground in the first direction x. In the second direction y, one second baffle plate 1031 of the two second baffle plates 103 is fastened to the other end of the one partition plate 1011, and the other second baffle plate 1032 of the two second baffle plates 103 is fastened to the other end of the other partition plate 1012.

When there is strong air convection in the second direction y outside the power conversion system, the second baffle plates 103 are disposed, so that the external air convection can be prevented, to a greatest extent, from blowing, into the air inlet 1121 of the power converter in the third column of power converters 21 or the air inlet 1121 of the power converter in the fourth column of power converters 22, the hot air discharged from the first column of power converters 11 and the second column of power converters 12, and the heat dissipation efficiency of the power conversion system is improved.

Further, in the first direction x, an end portion that is of the one second baffle plate 1031 and that is away from the ground is farther away from the ground than the air inlet 1121 of any power converter in the third column of power converters 21, and an end portion that is of the other second baffle plate 1032 and that is away from the ground is farther away from the ground than the air inlet 1121 of any power converter in the fourth column of power converters 22.

In other words, in the second direction y, the one second baffle plate 1031 shields the air inlet 1121 of any power converter in the third column of power converters 21, and the other second baffle plate 1032 shields the air inlet 1121 of any power converter in the fourth column of power converters 22.

Through this disposition, hot air can be better prevented from being sucked by the air inlets 1121 of the third column of power converters 21 by bypassing the one second baffle plate 1031, and hot air can be better prevented from being sucked by the air inlets 1121 of the fourth column of power converters 22 by bypassing the other second baffle plate 1032.

It should be noted that, during actual application, a quantity of second baffle plates 103 may change with the mounting site and the mounting environment. For example, one of the one second baffle plate 1031 or the other second baffle plate 1032 may alternatively be retained. This is not limited in this application.

### Embodiment 2:

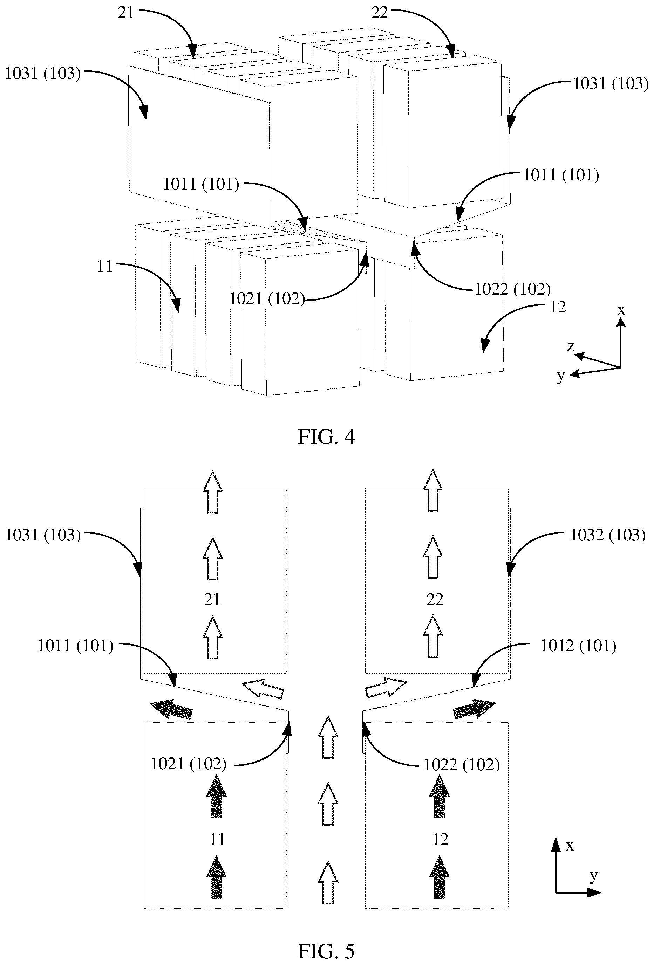

Refer to FIG. 4 and FIG. 5. FIG. 4 is a three-dimensional diagram of a power conversion system according to Embodiment 2 of this application, and FIG. 5 is a front view of the power conversion system according to Embodiment 2 of this application. A difference from Embodiment 1 is that, in the power conversion system provided in Embodiment 2, a distance between one partition plate 1011 and a third column of power converters 21 in a first direction x gradually decreases as a distance between the one partition plate 1011 and a second column of power converters 12 or a fourth column of power converters 22 in a second direction y increases, and a distance between the other partition plate 1012 and the fourth column of power converters 22 in the first direction x gradually decreases as a distance between the other partition plate 1012 and a first column of power converters or the third column of power converters 21 in the second direction y increases. That is, the two partition plates 101 symmetrically form a shape similar to an inverted splayed shape.

Through this disposition, hot air recirculation between a first layer of power converters and a second layer of power converters can also be avoided. Air in a passage between the first column of power converters 11 and the second column of power converters 12 may be sucked by air inlets 1121 of the third column of power converter and the fourth column of power converters 22 separately, and hot air discharged from the first column of power converter and the second column of power converters 12 through air outlets is not discharged into the passage between the first column of power converters 11 and the second column of power converters 12. Specifically, for a flow path of air in the first layer of power converters, refer to black arrows in FIG. 5. For a flow path of air in the second layer of power converters, refer to white arrows in FIG. 5.

Further, a difference from Embodiment 1 is that, in the power conversion system provided in Embodiment 2, one first baffle plate 1021 is disposed opposite to a right air outlet 1125 of the first column of power converters 11, and is configured to shield the right air outlet 1125 of the first column of power converters 11, and the other first baffle plate 1022 is disposed opposite to a left air outlet 1122 of the second column of power converters 12, and is configured to shield the left air outlet 1122 of the second column of power converters 12.

Through this disposition, hot air blown out from a left air outlet 1122 or a right air outlet 1125 of a power converter in the first layer of power converters can be prevented, to a greatest extent, from being sucked into an air inlet 1121 of a power converter in the second layer of power converters by bypassing edges of the partition plates 101, so that heat dissipation efficiency of the power conversion system is improved.

Further, in the first direction x, an end portion that is of the one first baffle plate 1021 and that is close to the ground is closer to the ground than a right air outlet 1125 of any power converter in the first column of power converters 11, and an end portion that is of the other first baffle plate 1022 and that is close to the ground is closer to the ground than a left air outlet 1122 of any power converter in the second column of power converters 12.

In other words, a projection of the right air outlet 1125 of any power converter in the first column of power converters 11 in the second direction y is located within a contour range of the one first baffle plate 1021, and a projection of the left air outlet 1122 of any power converter in the second column of power converters 12 in the second direction y is located within a contour range of the other first baffle plate 1022. Through this disposition, the hot air blown out from the first column of power converters 11 can be better prevented from being sucked by an air inlet 1121 of a power converter in the third column of power converters 21 by bypassing the one first baffle plate 1021, and the hot air blown out from the second column of power converters 12 can be better prevented from being sucked by an air inlet 1121 of a power converter in the fourth column of power converters 22 by bypassing the other first baffle plate 1022, so that the heat dissipation efficiency of the power conversion system is improved.

Further, a difference from Embodiment 1 is that, in the power conversion system provided in Embodiment 2, two second baffle plates 103 are not located in a passage between the third column of power converters 21 and the fourth column of power converters 22, but are located outer sides of the third column of power converters 21 and the fourth column of power converters 22 in the second direction y.

It should be noted that, during actual application, a quantity of second baffle plates 103 may change with a mounting site and a mounting environment. For example, one of the one first baffle plate 1021 or the other first baffle plate 1022 may be retained, and one of the one second baffle plate 1031 or the other second baffle plate 1032 may be retained. This is not limited in this application.

### Embodiment 3:

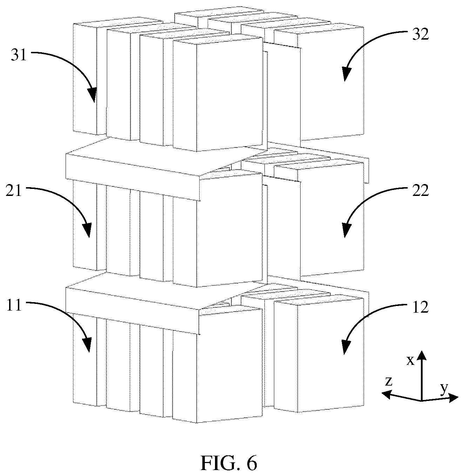

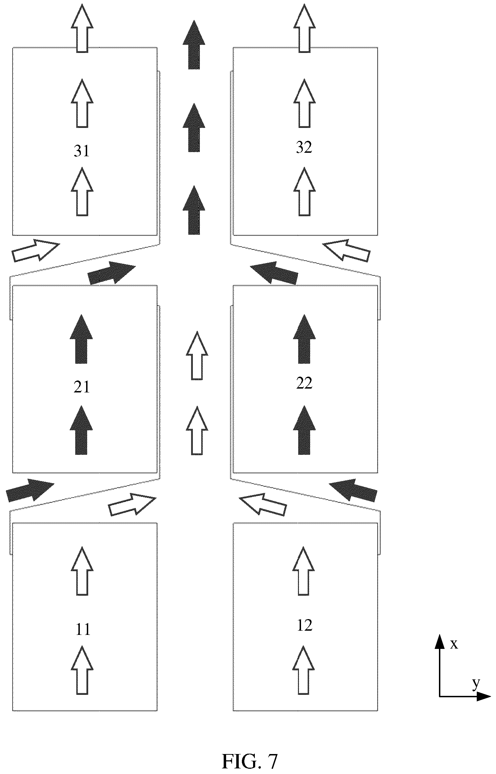

Refer to FIG. 6 and FIG. 7. FIG. 6 is a three-dimensional diagram of a power conversion system according to Embodiment 3 of this application, and FIG. 7 is a front view of the power conversion system according to Embodiment 3 of this application. A difference from Embodiment 1 is that, the power conversion system provided in Embodiment 3 includes three layers of power converters. A first layer of power converters, a second layer of power converters, and a third layer of power converters are sequentially stacked. The third layer of power converters includes a fifth column of power converters 31 and a sixth column of power converters 32 that are disposed opposite to each other and spaced apart in a second direction y. The fifth column of power converters 31 and a third column of power converters 21 are stacked and spaced apart in a first direction x. The sixth column of power converters 32 and a fourth column of power converters 22 are stacked and spaced apart in the first direction x.

Further, two partition plates 101, two first baffle plates 102, and two second baffle plates 103 are also included between the second layer of power converters and the third layer of power converters. For structures of the two partition plates 101 and positions of the two partition plates 101 relative to the second layer of power converters and the third layer of power converters, refer to the two partition plates 101 between the first layer of power converters and the second layer of power converters in Embodiment 1. For a connection relationship between the two partition plates 101 and both the two corresponding first baffle plates 102 and the two corresponding second baffle plates 103 or the like, refer to the two first baffle plates 102 and the two second baffle plates 103 that correspond to the first layer of power converters and the second layer of power converters in Embodiment 1. Details are not described herein again.

Specifically, for flow paths of air in the first layer of power converters and air in the third layer of power converters, refer to white arrows in FIG. 7. For a flow path of air in the second layer of power converters, refer to black arrows in FIG. 7.

### Embodiment 4:

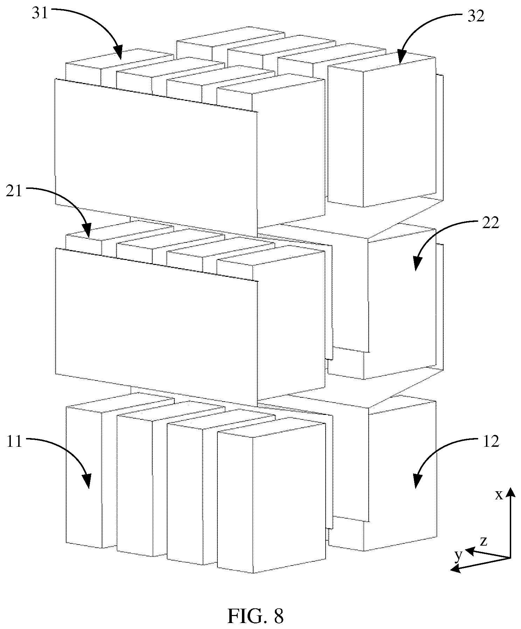

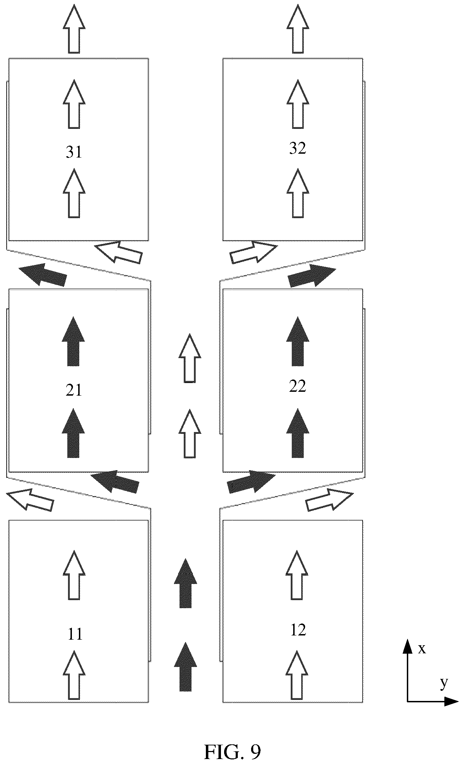

Refer to FIG. 8 and FIG. 9. FIG. 8 is a three-dimensional diagram of a power conversion system according to Embodiment 4 of this application, and FIG. 9 is a front view of the power conversion system according to Embodiment 4 of this application. A difference from Embodiment 2 is that, the power conversion system provided in Embodiment 4 includes three layers of power converters. A first layer of power converters, a second layer of power converters, and a third layer of power converters are sequentially stacked. The third layer of power converters includes a fifth column of power converters 31 and a sixth column of power converters 32 that are disposed opposite to each other and spaced apart in a second direction y. The fifth column of power converters 31 and a third column of power converters 21 are stacked and spaced apart in a first direction x. The sixth column of power converters 32 and a fourth column of power converters 22 are stacked and spaced apart in the first direction x.

Further, two partition plates 101, two first baffle plates 102, and two second baffle plates 103 are also included between the second layer of power converters and the third layer of power converters. For structures of the two partition plates 101 and positions of the two partition plates 101 relative to the second layer of power converters and the third layer of power converters, refer to the two partition plates 101 between the first layer of power converters and the second layer of power converters in Embodiment 2. For a connection relationship between the two partition plates 101 and both the two corresponding first baffle plates 102 and the two corresponding second baffle plates 103 or the like, refer to the two first baffle plates 102 and the two second baffle plates 103 that correspond to the first layer of power converters and the second layer of power converters in Embodiment 2. Details are not described herein again.

Specifically, for flow paths of air in the first layer of power converters and air in the third layer of power converters, refer to white arrows in FIG. 9. For a flow path of air in the second layer of power converters, refer to black arrows in FIG. 9.

### Embodiment 5:

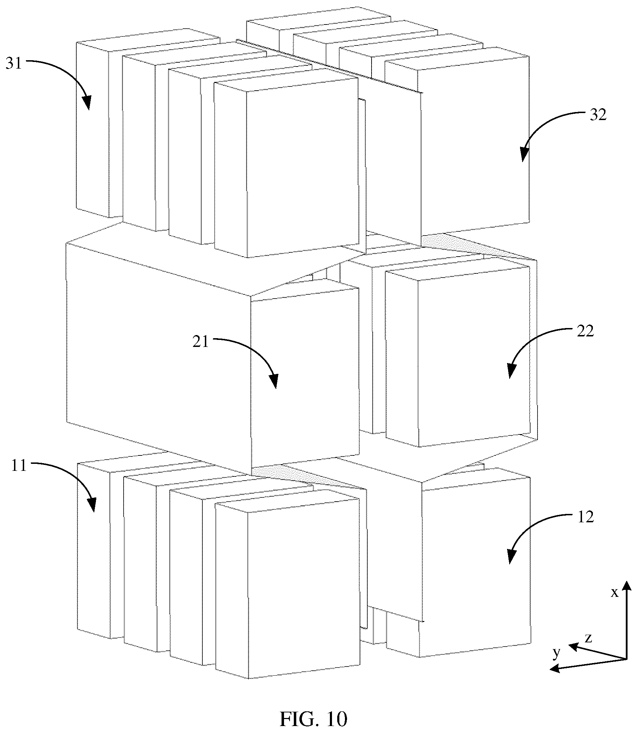

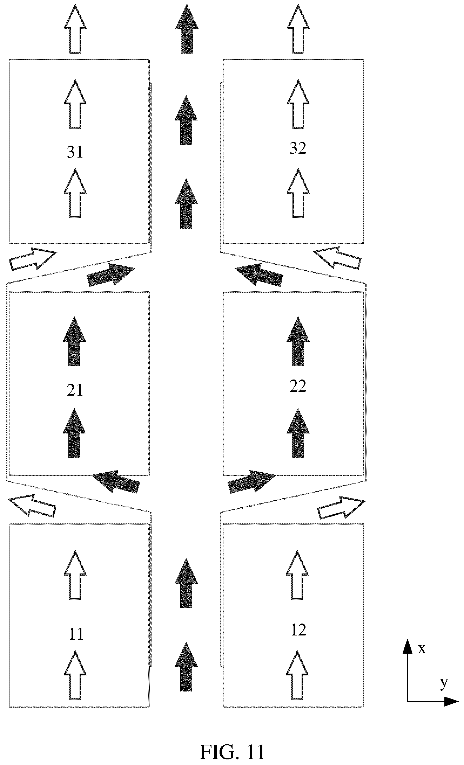

Refer to FIG. 10 and FIG. 11. FIG. 10 is a three-dimensional diagram of a power conversion system according to Embodiment 5 of this application, and FIG. 11 is a front view of the power conversion system according to Embodiment 5 of this application. A difference from Embodiment 2 is that, the power conversion system provided in Embodiment 5 includes three layers of power converters. A first layer of power converters, a second layer of power converters, and a third layer of power converters are sequentially stacked. The third layer of power converters includes a fifth column of power converters 31 and a sixth column of power converters 32 that are disposed opposite to each other and spaced apart in a second direction y. The fifth column of power converters 31 and a third column of power converters 21 are stacked and spaced apart in a first direction x. The sixth column of power converters 32 and a fourth column of power converters 22 are stacked and spaced apart in the first direction x.

Further, two partition plates 101, two first baffle plates 102, and two second baffle plates 103 are also included between the second layer of power converters and the third layer of power converters. For structures of the two partition plates 101 and positions of the two partition plates 101 relative to the second layer of power converters and the third layer of power converters, refer to the two partition plates 101 between the first layer of power converters and the second layer of power converters in Embodiment 1. For a connection relationship between the two partition plates 101 and both the two corresponding first baffle plates 102 and the two corresponding second baffle plates 103 or the like, refer to the two first baffle plates 102 and the two second baffle plates 103 that correspond to the first layer of power converters and the second layer of power converters in Embodiment 1. Details are not described herein again.

Specifically, for flow paths of air in the first layer of power converters and air in the third layer of power converters, refer to white arrows in FIG. 11. For a flow path of air in the second layer of power converters, refer to black arrows in FIG. 11.

### Embodiment 6:

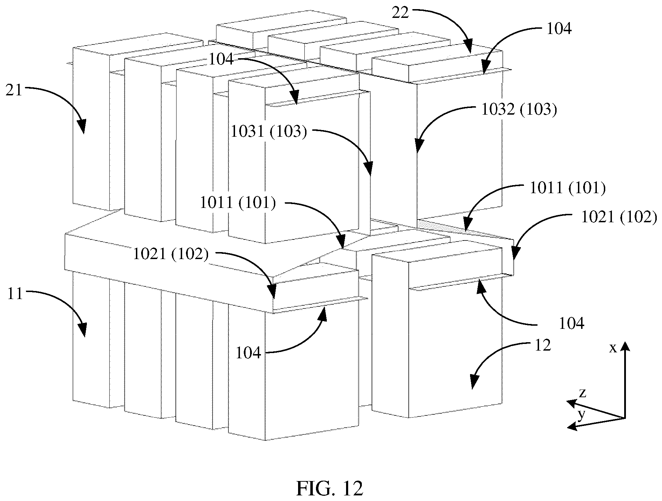

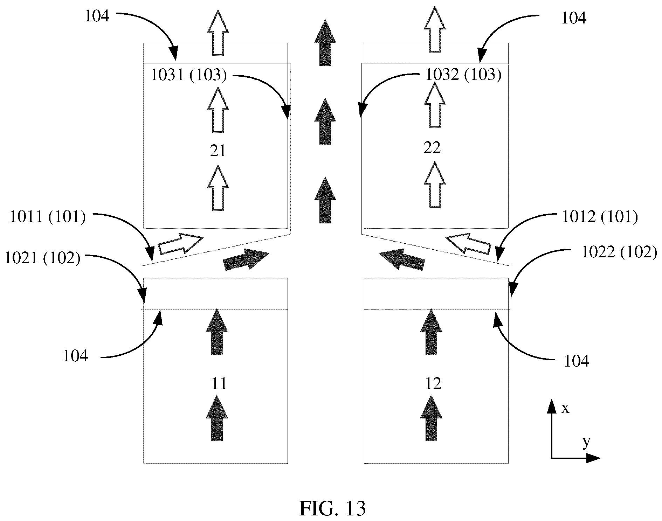

Refer to FIG. 12 and FIG. 13. FIG. 12 is a three-dimensional diagram of a power conversion system according to Embodiment 6 of this application, and FIG. 13 is a front view of the power conversion system according to Embodiment 6 of this application. A difference from Embodiment 1 is that, the power conversion system provided in Embodiment 6 further includes a plurality of third baffle plates 104. The third baffle plate 104 is connected between two adjacent power converters in any column of power converters among a first column of power converters 11, a second column of power converters 12, a third column of power converters 21, and a fourth column of power converters 22. In a first direction x, a third baffle plate 104 connected between two adjacent power converters in the first column of power converters 11 is closer to the ground than front air outlets 1124 or rear air outlets 1123 of the power converters connected to the third baffle plate 104 in the first column of power converters 11, a third baffle plate 104 connected between two adjacent power converters in the second column of power converters 12 is closer to the ground than front air outlets 1124 or rear air outlets 1123 of the power converters connected to the third baffle plate 104, a third baffle plate 104 connected between two adjacent power converters in the third column of power converters 21 is closer to the ground than front air outlets 1124 or rear air outlets 1123 of the power converters connected to the third baffle plate 104 in the third column of power converters 21, and a third baffle plate 104 connected between two adjacent power converters in the fourth column of power converters 22 is closer to the ground than front air outlets 1124 or rear air outlets 1123 of the power converters connected to the third baffle plate 104 in the fourth column of power converters 22.

It should be noted that a quantity of third baffle plates 104 may be set as required. In other words, there may be one or more third baffle plates 104. This is not limited in this embodiment of this application.

Through this disposition, when there is strong external convection in the first direction x, the strong external convection can be prevented from blowing hot air discharged from an air outlet of a power converter in any column of power converters into an air inlet 1121 of the power converter in the column of power converters, so that heat dissipation efficiency of the power conversion system is improved.

Further, in a second direction y, an edge of the third baffle plate 104 located between the two adjacent power converters exceeds edges of the two adjacent power converters.

Through this disposition, hot air can be prevented, to a greatest extent, from being sucked by air inlets 1121 of the two adjacent power converters by bypassing the edge of the third baffle plate 104 between the two adjacent power converters, so that the heat dissipation efficiency of the power conversion system is improved.

It should be noted that, during actual application, an edge of the third baffle plate 104 located between the two adjacent power converters may alternatively be flush with edges of the two adjacent power converters. This is not limited in this application.

Through this disposition, hot air can be prevented, to a greatest extent, from being sucked by air inlets 1121 of the two adjacent power converters by bypassing the edge of the third baffle plate 104 between the two adjacent power converters, so that the heat dissipation efficiency of the power conversion system is improved.

It should be noted that, in FIG. 12 and FIG. 13, third baffle plates 104 corresponding to the first column of power converters 11 and the second column of power converters 12 are fastened to first baffle plates 102, and third baffle plates 104 corresponding to the third column of power converters 21 and the fourth column of power converters 22 are fastened to second baffle plates 103. That is, partition plates 101, the first baffle plates 102, the second baffle plates 103, and the third baffle plates 104 are of an integrated structure. Through this disposition, mounting and processing can be facilitated. It should be noted that the "integrated structure" is not limited to being "integrally formed" in processing, provided that a whole can be formed through mutual connection. This is not limited in this application. For example, during actual application, the third baffle plates 104 and the remaining partition plates, first baffle plates, and second baffle plates may alternatively be separated components, but the third baffle plates, the partition plates, the first baffle plates, and the second baffle plates may be mounted and fastened to each other, to finally form an integrated structure.

Specifically, for a flow path of air in a first layer of power converters, refer to black arrows in FIG. 13. For a flow path of air in a second layer of power converters, refer to white arrows in FIG. 13.

### Embodiment 7:

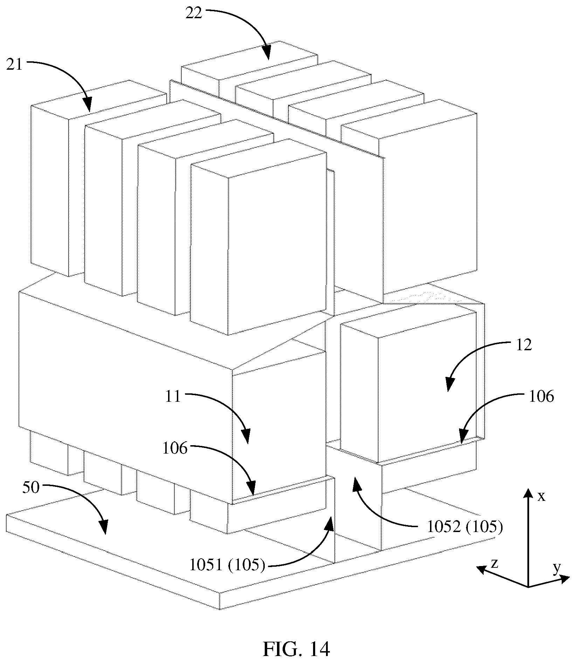

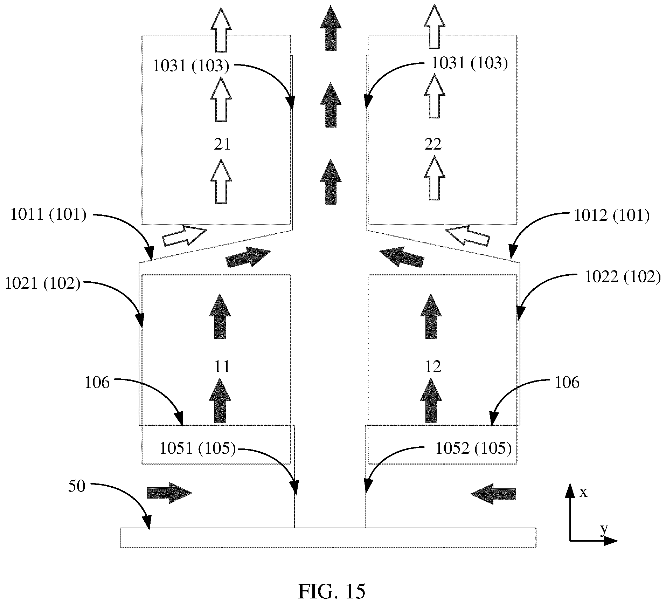

Refer to FIG. 14 and FIG. 15. FIG. 14 is a three-dimensional diagram of a power conversion system according to Embodiment 7 of this application, and FIG. 15 is a front view of the power conversion system according to Embodiment 7 of this application. A difference from Embodiment 1 is that, the power conversion system provided in Embodiment 7 further includes two fourth baffle plates 105. Specifically, both the two fourth baffle plates 105 extend in a first direction x and a third direction z, and the two fourth baffle plates 105 are disposed in a spacing region between a first column of power converters 11 and a second column of power converters 12. One fourth baffle plate 1051 of the two fourth baffle plates 105 and the other fourth baffle plate 1052 of the two fourth baffle plates 105 are disposed opposite to each other in a second direction y. It should be noted that, in Embodiment 1, a first layer of power converters including the first column of power converters 11 and the second column of power converters 12 and a second layer of power converters including the third column of power converters 21 and the fourth column of power converters 22 are any two adjacent layers of power converters in the power conversion system. In the first direction x, the first layer of power converters is closer to the ground than the second layer of power converters. However, in Embodiment 7, a first layer of power converters including the first column of power converters 11 and the second column of power converters 12 is specifically a layer of power converters closest to the ground in the power conversion system.

Still refer to FIG. 14 and FIG. 15. In the first direction x, an end portion that is of the one fourth baffle plate 1051 and that is away from the ground is farther away from the ground than an air inlet 1121 of a power converter in the first column of power converters, and an end portion that is of the one fourth baffle plate 1051 and that is close to the ground is closer to the ground than the air inlet 1121 of the power converter in the first column of power converters. Similarly, in the first direction x, an end portion that is of the other fourth baffle plate 1052 and that is away from the ground is farther away from the ground than an air inlet 1121 of a power converter in the second column of power converters, and an end portion that is of the other fourth baffle plate 1052 and that is close to the ground is closer to the ground than the air inlet 1121 of the power converter in the second column of power converters.

During actual application, in the first direction x, a distance between the ground and an end portion that is of the fourth baffle plate 105 and that is away from the ground may alternatively be equal to a distance between the ground and an air inlet of a power converter in a column of power converters that corresponds to the fourth baffle plate 105.

It should be noted that a quantity of fourth baffle plates 105 may be set as required. In other words, there may be one or more fourth baffle plates 105. This is not limited in this embodiment of this application.

When there is strong external convection in the second direction y, the fourth baffle plate 105 is disposed, so that the strong convection can be prevented from quickly flowing between the bottoms of the first column of power converters 11 and the second column of power converters 12, air intake volumes of the first column of power converters 11 and the second column of power converters 12 are further increased, and heat dissipation efficiency of the power conversion system is improved.

Further, in the second direction y, a distance between the one fourth baffle plate 1051 and the first column of power converters 11 is less than a distance between the other fourth baffle plate 1052 and the first column of power converters 11, and a distance between the other fourth baffle plate 1052 and the second column of power converters 12 is less than a distance between the one fourth baffle plate 1051 and the second column of power converters 12.

Through this disposition, air between the first column of power converters 11 and the ground can be better blocked, and similarly, air between the second column of power converters 12 and the ground can also be blocked, to increase the air intake volumes of the first column of power converters 11 and the second column of power converters 12.

Further, still refer to FIG. 14 and FIG. 15. A difference from Embodiment 1 is that, the power conversion system provided in Embodiment 7 further includes a base 50. The base 50 is disposed on the ground, and is configured to carry the power converter. It should be noted that, during actual application, the power conversion system generally further includes a support structure (not shown), for example, a bracket. The support structure is configured to hang or mount the power converter, and the support structure is placed on the base 50. The base 50 is disposed, so that stable support can be provided for the power converter, to ensure stable disposition of the power conversion system.

Further, an end portion that is of the fourth baffle plate 105 and that is close to the ground is fastened to the base 50. Through this disposition, the air between the first column of power converters 11 and the ground can be better blocked, and the air between the second column of power converters 12 and the ground can also be better blocked, to increase the air intake volumes of the first column of power converters 11 and the second column of power converters 12.

It should be noted that, during actual application, the fourth baffle plate 105 may alternatively extend in a first direction x and a second direction y. In a third direction z, the fourth baffle plate 105 is disposed on an outer side of a first column of power converters 11 or a second column of power converters 12. In the first direction x, an end portion that is of the fourth baffle plate 105 and that is away from the ground is farther away from the ground than an air inlet 1121 of any power converter in the first layer of power converters.

Similarly, when there is strong external convection in the third direction z, the fourth baffle plate 105 is disposed, so that the strong convection can be prevented from quickly flowing between the bottoms of the first column of power converters 11 and the second column of power converters 12, air intake volumes of the first column of power converters 11 and the second column of power converters 12 are further increased, and heat dissipation efficiency of the power conversion system is improved.

Further, the power conversion system further includes a plurality of fifth baffle plates 106. The fifth baffle plate 106 is connected between two adjacent power converters in any column of power converters in the first column of power converters 11 and the second column of power converters 12. In the first direction x, a fifth baffle plate 1061 connected between two adjacent power converters in the first column of power converters 11 is farther away from the ground than air inlets 1121 of the power converters connected to the fifth baffle plate 1061, and a fifth baffle plate 1062 connected between two adjacent power converters in the second column of power converters 12 is farther away from the ground than air inlets 1121 of the power converters connected to the fifth baffle plate 1062.

It should be noted that, during actual application, the fifth baffle plate 106 may be disposed as required. In other words, there may be one or more fifth baffle plates 106. This is not limited in this application.

When there is strong external convection in the third direction z, the fifth baffle plate 106 is disposed, so that hot air discharged from an air outlet of the power converter in the first column of power converters 11 can be prevented, to a greatest extent, from being blown into the air inlet 1121 of the power converter. Similarly, hot air discharged from an air outlet of the power converter in the second column of power converters 12 can also be prevented, to a greatest extent, from being sucked by the air inlet 1121 of the power converter, so that the heat dissipation efficiency of the power conversion system is improved.

Further, in the second direction y, an edge of the fifth baffle plate 106 located between the two adjacent power converters exceeds edges of the two adjacent power converters.

Through this disposition, hot air can be prevented, to a greatest extent, from being sucked by air inlets 1121 of the two adjacent power converters by bypassing the edge of the fifth baffle plate 106 between the two adjacent power converters, so that the heat dissipation efficiency of the power conversion system is improved.

It should be noted that, during actual application, in the second direction y, an edge of the fifth baffle plate 106 located between the two adjacent power converters may alternatively be flush with edges of the two adjacent power converters. This is not limited in this application.

It should be noted that, in FIG. 14 and FIG. 15, the one fourth baffle plate 1051 is fastened to the fifth baffle plate 106 connected between the two adjacent power converters in the first column of power converters 11, and the other fourth baffle plate 1052 is fastened to the fifth baffle plate 106 connected between the two adjacent power converters in the second column of power converters 12. That is, the fourth baffle plates 105 and the fifth baffle plates 106 are of an integrated structure. Through this disposition, mounting and processing can be facilitated. It should be noted that the "integrated structure" is not limited to being "integrally formed" in processing, provided that a whole can be formed through mutual connection. This is not limited in this application. For example, during actual application, the fourth baffle plates 105 and the fifth baffle plates 106 may alternatively be separated, but the fourth baffle plates 105 and the fifth baffle plates 106 may be mounted and fastened to each other, to finally form an integrated structure. This is not limited in this application.

Specifically, for a flow path of air in the first layer of power converters, refer to black arrows in FIG. 15. For a flow path of air in the second layer of power converters, refer to white arrows in FIG. 15.

### Embodiment 8:

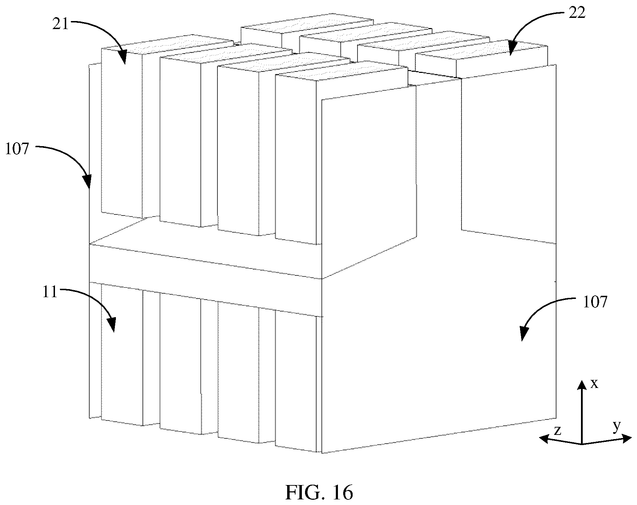

FIG. 16 is a three-dimensional diagram of a power conversion system according to Embodiment 8 of this application. A difference from Embodiment 1 is that, the power conversion system provided in Embodiment 8 further includes two sixth baffle plates 107. The two sixth baffle plates 107 extend in a first direction x and a second direction y, and the two sixth baffle plates 107 are disposed opposite to each other and abut against a partition plate 101 in a third direction z. In the third direction z, projections of a plurality of power converters are located within a contour range of the sixth baffle plate 107.

The sixth baffle plate 107 is disposed, so that hot air discharged from a power converter that is arranged on an outermost side of a first column of power converters 11 in the third direction z can be prevented, to a greatest extent, from being sucked, by bypassing an edge of the partition plate 101 between the first column of power converters 11 and a third column of power converters 21, by an air inlet 1121 of a power converter that is in the third column of power converters 21 and that is disposed opposite to the power converter in the first direction x. Similarly, hot air discharged from a power converter that is arranged on an outermost side of a second column of power converters 12 in the third direction z can also be prevented from being sucked, by bypassing an edge of the partition plate 101 between the second column of power converters 12 and a fourth column of power converters 22, by an air inlet 1121 of a power converter that is in the fourth column of power converters 22 and that is disposed opposite to the power converter in the first direction x. Therefore, heat dissipation efficiency of the power conversion system is improved.

It should be noted that, during actual application, a quantity of sixth baffle plates 107 may be set as required. In other words, there may be one or more sixth baffle plates 107. This is not limited in this application.

### Embodiment 9:

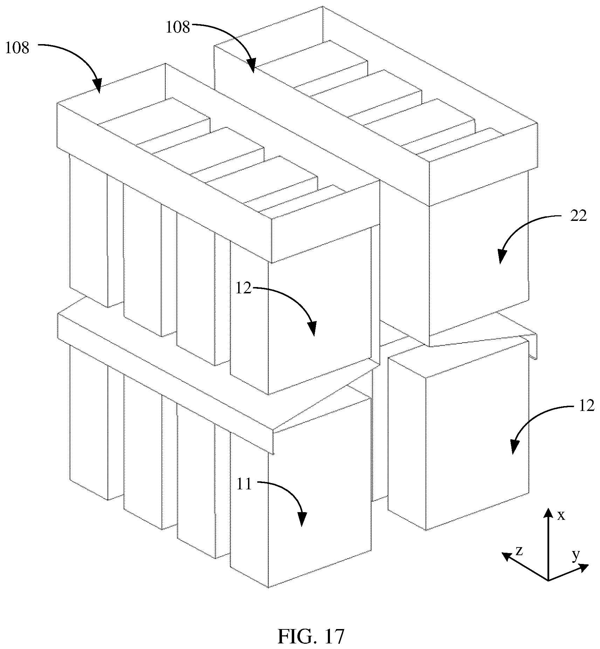

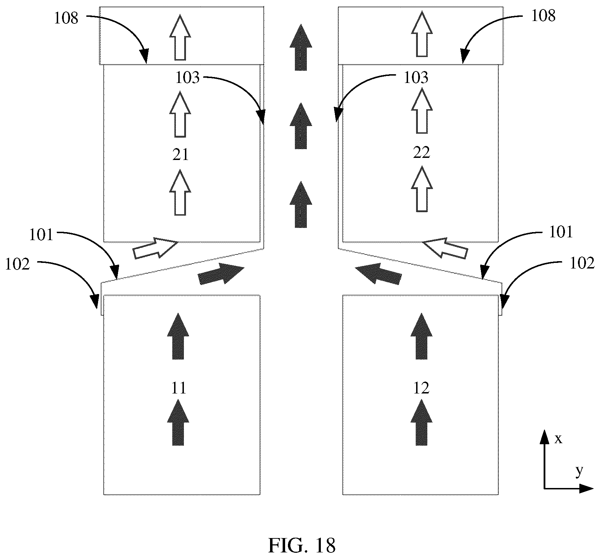

Refer to FIG. 17 and FIG. 18. FIG. 17 is a three-dimensional diagram of a power conversion system according to Embodiment 9 of this application, and FIG. 18 is a front view of the power conversion system according to Embodiment 9 of this application. A difference from Embodiment 1 is that, the power conversion system provided in Embodiment 9 further includes two seventh baffle plates 108. The seventh baffle plate 108 is of a frame shape and extends in a first direction x, and the seventh baffle plate 108 is sleeved on a periphery of power converters in a second layer of power converters. It should be noted that, when the power conversion system includes more than two layers of power converters, the seventh baffle plate 108 is sleeved on a periphery of any column of power converters in a layer of power converters farthest away from the ground (namely, a topmost layer of power converters) in the power conversion system. In addition, during actual application, the seventh baffle plate 108 may alternatively be disposed as required. In other words, the seventh baffle plate 108 may be disposed only for one or more columns of power converters.

Further, in the first direction x, an end portion that is of the seventh baffle plate 108 and that is close to the ground is closer to the ground than an air outlet of any power converter in the column of power converters on which the seventh baffle plate 108 is sleeved, and an end portion that is of the seventh baffle plate 108 and that is away from the ground is farther away from the ground than the air outlet of any power converter in the column of power converters on which the seventh baffle plate 108 is sleeved.

When there is strong external convection in a second direction y or a third direction z, the seventh baffle plate 108 is disposed, so that the strong external convection can be blocked to a greatest extent, to smoothly discharge hot air by a topmost layer of power converters, and heat dissipation efficiency of the power conversion system is improved.

Specifically, for a flow path of air in a first layer of power converters, refer to black arrows in FIG. 18. For a flow path of air in the second layer of power converters, refer to white arrows in FIG. 18.

### Embodiment 10:

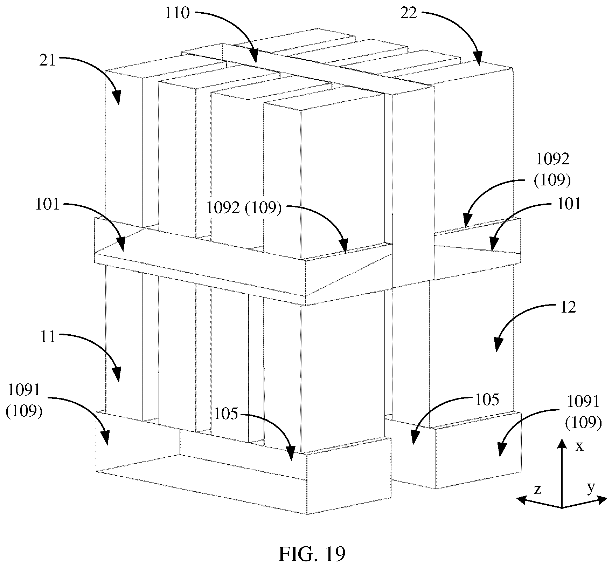

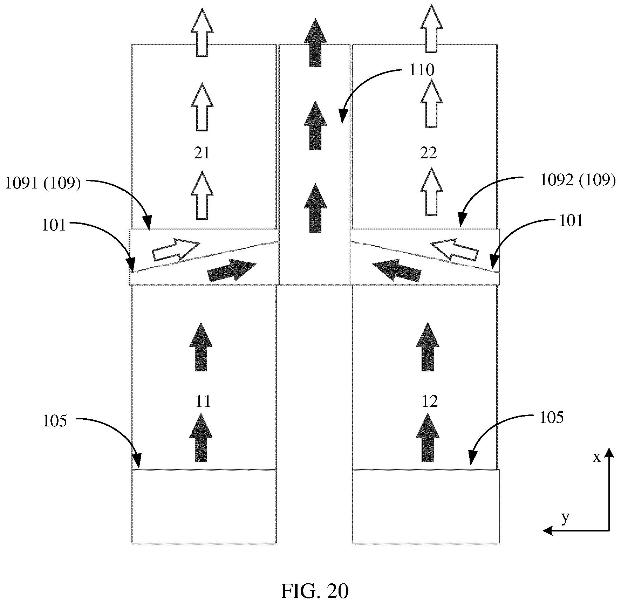

Refer to FIG. 19 and FIG. 20. FIG. 19 is a three-dimensional diagram of a power conversion system according to Embodiment 10 of this application, and FIG. 20 is a front view of the power conversion system according to Embodiment 10 of this application. A difference from Embodiment 1 is that, in the power conversion system provided in Embodiment 10, first baffle plates 102 and second baffle plates 103 are omitted. In addition, an air guide cover 109 is further added. The air guide cover 109 includes a lower-layer air guide cover 1091 and an upper-layer air guide cover 1092. The lower-layer air guide cover 1091 is located between a first layer of power converters and the ground, and the upper-layer air guide cover 1092 is located between the first layer of power converters and a second layer of power converters. In FIG. 19 and FIG. 20, the power conversion system includes two lower-layer air guide covers 1091. One lower-layer air guide cover 1091 is located between a first column of power converters 11 and the ground, and the other air guide cover 109 is located between a second column of power converters 12 and the ground.

Further, the lower-layer air guide cover 1091 also includes the fourth baffle plate 105 described in Embodiment 7. In a third direction z, two ends of the fourth baffle plate 105 are further connected to two first connection plates disposed opposite to each other in the third direction z.

Further, in a first direction x, the lower-layer air guide cover 1091 further includes two first support plates that are disposed opposite to each other and spaced apart, and the two first support plates are fastened to the fourth baffle plate 105 and the first connection plate, to jointly form a cover body.

Further, in a second direction y, both air inlets 1121 of the two lower-layer air guide covers 1091 take in air from the outside of the power conversion system. Certainly, during actual application, both air inlets 1121 of the two lower-layer air guide covers 1091 may alternatively take in air from the inside of the power conversion system. That is, air is taken in from a passage between the first column of power converters 11 and the second column of power converters 12.

The lower-layer air guide cover 1091 is disposed, so that air can be better blocked. This helps the first layer of power converters suck the air outside the power conversion system.

Further, two second connection plates that are disposed opposite to each other and spaced apart in the third direction z and two second support plates that are disposed opposite to each other and spaced apart in the first direction x are disposed on the upper-layer air guide cover 1092. The two second connection plates and the two second support plates enclose accommodation space, and a partition plate 101 is disposed in the accommodation space. For a structure of the partition plate 101 and position relationships between the partition plate 101 and both the first layer of power converters and the second layer of power converters, refer to Embodiment 1 and Embodiment 2. Details are not described herein again.

The upper-layer air guide cover 1092 is disposed, so that cold air can be better guided into heat dissipation cavities 112 of the second layer of power converters.

Further, an air duct cover 110 is further added to the power conversion system provided in Embodiment 10. The air duct cover 110 includes two third connection plates that are disposed opposite to each other and spaced apart in the second direction y and two fourth connection plates that are disposed opposite to each other and spaced apart in the third direction z. The third connection plates and the fourth connection plates are sequentially connected to enclose an air duct. The air duct cover 110 communicates with an air outlet of the first layer of power converters, so that hot air discharged from the first layer of power converters is smoothly discharged from the power conversion system, and hot air recirculation is avoided.

Specifically, for a flow path of air in the first layer of power converters, refer to black arrows in FIG. 20. For a flow path of air in the second layer of power converters, refer to white arrows in FIG. 20.

It should be noted that, in the accompanying drawings of the power conversion systems provided in all embodiments of this application, a first direction x, a second direction y, and a third direction z are not limited by directions of arrows. In other words, an opposite direction of the arrow is also a corresponding direction.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power conversion system, comprising a plurality of power converters and two partition plates, wherein
the plurality of power converters are configured to: convert a direct current from a photovoltaic module or an energy storage battery into an alternating current, and transmit the alternating current to a power grid, the plurality of power converters comprise at least two layers of power converters that are stacked and spaced apart in a first direction, each layer of power converters in the at least two layers of power converters comprises at least two columns of power converters that are disposed opposite to each other and spaced apart in a second direction, and each column of power converters in the at least two columns of power converters comprises at least two power converters that are spaced apart in a third direction, wherein the first direction, the second direction, and the third direction are perpendicular to each other;
the power converter comprises an air inlet and an air outlet, air outside the power converter enters the power converter from the air inlet and then is blown out from the air outlet, and the air inlet is closer to the ground than the air outlet in the first direction;
the at least two layers of power converters comprise a first layer of power converters and a second layer of power converters that are adjacent, the first layer of power converters is closer to the ground than the second layer of power converters in the first direction, the first layer of power converters comprises a first column of power converters and a second column of power converters, the second layer of power converters comprises a third column of power converters and a fourth column of power converters, and in the first direction, the first column of power converters and the third column of power converters are stacked and spaced apart, and the second column of power converters and the fourth column of power converters are stacked and spaced apart; and
one of the two partition plates is disposed between the first column of power converters and the third column of power converters, the other of the two partition plates is disposed between the second column of power converters and the fourth column of power converters, both the one partition plate and the other partition plate extend in the second direction and the third direction, and the one partition plate and the other partition plate are symmetrically disposed.

2. The power conversion system according to claim 1, wherein a projection of the first column of power converters in the first direction is located within a contour range of a projection of the one partition plate, and a projection of the second column of power converters in the first direction is located within a contour range of a projection of the other partition plate.

3. The power conversion system according to claim 1 or 2, wherein both the one partition plate and the other partition plate are disposed obliquely relative to the first direction.

4. The power conversion system according to claim 3, wherein a distance between the one partition plate and the third column of power converters in the first direction gradually decreases as a distance between the one partition plate and the second column of power converters or the fourth column of power converters in the second direction decreases, and a distance between the other partition plate and the fourth column of power converters in the first direction gradually decreases as a distance between the other partition plate and the first column of power converters or the third column of power converters in the second direction decreases.

5. The power conversion system according to claim 3, wherein a distance between the one partition plate and the third column of power converters in the first direction gradually increases as a distance between the one partition plate and the second column of power converters or the fourth column of power converters in the second direction decreases, and a distance between the other partition plate and the fourth column of power converters in the first direction gradually increases as a distance between the other partition plate and the first column of power converters or the third column of power converters in the second direction decreases.

6. The power conversion system according to any one of claims 1 to 5, wherein the air outlet comprises a left air outlet and a right air outlet that are disposed opposite to each other in the second direction;
the power conversion system further comprises two first baffle plates, the first baffle plate extends toward the ground in the first direction, one of the two first baffle plates is fastened to an end of the one partition plate in the second direction, and the other of the two first baffle plates is fastened to an end of the other partition plate in the second direction; and
the first baffle plate is disposed opposite to the left air outlet or the right air outlet in the second direction, and the first baffle plate is configured to shield the left air outlet or the right air outlet.

7. The power conversion system according to claim 6, wherein in the first direction, an end portion that is of the one first baffle plate and that is close to the ground is closer to the ground than a left air outlet of any power converter in the first column of power converters, the one first baffle plate is configured to shield left air outlets of the first column of power converters, an end portion that is of the other first baffle plate and that is close to the ground is closer to the ground than a right air outlet of any power converter in the second column of power converters, and the other first baffle plate is configured to shield right air outlets of the second column of power converters.

8. The power conversion system according to claim 6, wherein in the first direction, an end portion that is of the one first baffle plate and that is close to the ground is closer to the ground than a right air outlet of any power converter in the first column of power converters, the one first baffle plate is configured to shield right air outlets of the first column of power converters, an end portion that is of the other first baffle plate and that is close to the ground is closer to the ground than a left air outlet of any power converter in the second column of power converters, and the other first baffle plate is configured to shield left air outlets of the second column of power converters.

9. The power conversion system according to any one of claims 1 to 6, wherein the power conversion system further comprises two second baffle plates, the second baffle plate extends away from the ground in the first direction, one of the two second baffle plates is fastened to the other end of the one partition plate in the second direction, the other of the two second baffle plates is fastened to the other end of the other partition plate in the second direction, the one second baffle plate is configured to shield an air inlet of any power converter in the third column of power converters, and the other second baffle plate is configured to shield an air inlet of any power converter in the fourth column of power converters.

10. The power conversion system according to claim 9, wherein in the first direction, an end portion that is of the one second baffle plate and that is away from the ground is farther away from the ground than the air inlet of any power converter in the third column of power converters, and an end portion that is of the other second baffle plate and that is away from the ground is farther away from the ground than the air inlet of any power converter in the fourth column of power converters.

11. The power conversion system according to any one of claims 1 to 10, wherein the air outlet comprises at least one of a front air outlet and a rear air outlet, both an air direction in which air is blown out from the front air outlet and an air direction in which air is blown out from the rear air outlet extend in the third direction, and when both the front air outlet and the rear air outlet exist, the front air outlet and the rear air outlet are disposed opposite to each other in the third direction;
the power conversion system further comprises one or more third baffle plates, and the third baffle plate is connected between two adjacent power converters in any column of power converters among the first column of power converters, the second column of power converters, the third column of power converters, or the fourth column of power converters; and
in the first direction, a third baffle plate connected between two adjacent power converters in the first column of power converters is closer to the ground than a front air outlets or a rear air outlets of the two power converters connected to the third baffle plate, a third baffle plate connected between two adjacent power converters in the second column of power converters is closer to the ground than a front air outlets or a rear air outlets of the two power converters connected to the third baffle plate, a third baffle plate connected between two adjacent power converters in the third column of power converters is closer to the ground than a front air outlets or a rear air outlets of the two power converters connected to the third baffle plate, and a third baffle plate connected between two adjacent power converters in the fourth column of power converters is closer to the ground than a front air outlets or a rear air outlets of the two power converters connected to the third baffle plate.

12. The power conversion system according to claim 11, wherein in the second direction, an edge of a third baffle plate located between the two adjacent power converters exceeds edges of the two adjacent power converters or is flush with edges of the two adjacent power converters.

13. The power conversion system according to any one of claims 1 to 12, wherein the power conversion system further comprises one or more fourth baffle plates, the fourth baffle plate extends in the first direction and the third direction, and the fourth baffle plate is disposed in a spacing region between the first column of power converters and the second column of power converters; and
in the first direction, an end portion that is of the fourth baffle plate and that is away from the ground is farther away from the ground than an air inlet of any power converter in the first layer of power converters, an end portion that is of the fourth baffle plate and that is close to the ground is closer to the ground than the air inlet of any power converter in the first layer of power converters, and the first layer of power converters is a layer of power converters closest to the ground in the power conversion system.

14. The power conversion system according to claim 13, wherein when the power conversion system comprises two fourth baffle plates, one of the two fourth baffle plates is disposed opposite to the other fourth baffle plate in the second direction; and
in the second direction, a distance between the one fourth baffle plate and the first column of power converters is less than a distance between the other fourth baffle plate and the first column of power converters, and a distance between the other fourth baffle plate and the second column of power converters is less than a distance between the one fourth baffle plate and the second column of power converters.

15. The power conversion system according to any one of claims 1 to 12, wherein the power conversion system further comprises one or more fourth baffle plates, the fourth baffle plate extends in the first direction and the second direction, and in the third direction, the fourth baffle plate is disposed on an outer side of at least one column of power converters in the first layer of power converters; and
in the first direction, an end portion that is of the fourth baffle plate and that is away from the ground is farther away from the ground than air inlets of the at least one column of power converters in the first layer of power converters, an end portion that is of the fourth baffle plate and that is close to the ground is closer to the ground than the air inlets of the at least one column of power converters in the first layer of power converters, and the first layer of power converters is a layer of power converters closest to the ground in the power conversion system.
